# EUROPÄISCHE PATENTANMELDUNG

(11) **EP 4 622 016 A1**
(43) Veröffentlichungstag der Anmeldung: **24.09.2025**
(21) Anmeldenummer: 24164864.1
(22) Anmeldetag: 20.03.2024
(51) Int. Cl.: H01R 13/58, G01K 7/00, C09J 7/00, C09D 179/08, H01C 1/14, H01G 2/06, H01L 23/00, H05K 1/18, H01R 12/53, H01C 17/28

(54) **ELEKTRISCHE ISOLATION VON ANSCHLUSSDRÄHTEN MIT RESTELASTIZITÄT AN KONTAKTPADS**

(71) Anmelder: Yageo Nexensos GmbH, 63801 Kleinostheim (DE)
(72) Erfinder: SANDER, Margit, 63801 Kleinostheim (DE); ASMUS, Tim, 63801 Kleinostheim (DE); ZINKEVICH, Matsvei, 63801 Kleinostheim (DE)
(74) Vertreter: Meissner Bolte Partnerschaft mbB

(57) **Zusammenfassung**

Beschrieben wird ein Fixiertropfen, zur Isolation von Anschlussdrähten an passiven Bauelementen, insbesondere Sensoren, vorzugsweise Temperatursensoren, auf einem anorganischen Substrat, insbesondere Metalloxid-, Halbleiter- und/oder Glassubstrat, wobei der Fixiertropfen eine hydrophobe Polymerzusammensetzung umfasst, ein passives Bauelement, ein Verfahren zur Herstellung eines passiven Bauelements, ein passives Bauelement erhältlich durch dieses Verfahren, sowie die Verwendung solcher Fixiertropfen zur Isolation von Anschlussdrähten an passiven Bauelementen.

## Beschreibung

Die vorliegende Erfindung betrifft elektrisch isolierende Fixiertropfen, ein passives Bauelement, ein Verfahren zur Herstellung eines passiven Bauelements, ein passives Bauelement erhältlich durch dieses Verfahren, sowie die Verwendung solcher Fixiertropfen zur elektrischen Isolation von Anschlussdrähten an passiven Bauelementen.

Unter passiven Bauelementen werden in der Regel jene Bauelemente verstanden, die, im Gegensatz zu aktiven Bauelementen, keine Verstärkerwirkung zeigen und keine Steuerungsfunktion besitzen. Beispiele für passive Bauelemente wären z.B. Widerstände, Kondensatoren, Sensoren und Heizer.

Im Sinne der Erfindung umfasst ein passives Bauelement vorzugsweise ein Substrat, eine mehrlagige Struktur, die sich auf dem Substrat befindet, mindestens einen Anschlussdraht und einen Fixiertropfen zur Isolation, zur Fixierung und bei Niedertemperaturanwendungen nur im geringen Maße zur Zugentlastung des mindestens einen Anschlussdrahts. Als Anschlussdraht ist auch eine Litze oder kompaktierte Litze möglich. Die mehrlagige Struktur wiederum umfasst vorzugsweise mindestens ein Kontaktpad, an dem der mindestens eine Anschlussdraht fixiert ist, mindestens eine elektrische Leiterbahn, und mindestens eine dielektrische Schicht, beispielsweise eine siebgedruckte Glasschicht oder einer Polymerschicht, die die Leiterbahn bedeckt, aber das Kontaktpad im Wesentlichen freilässt.

Fixiertropfen dienen vorwiegend zur Zugentlastung des mindestens einen Anschlussdrahts. Bei Sensoren für Einsatztemperaturen über 200°C sind die Fixiertropfen bevorzugt aus Glas oder Glaskeramik. Weiterhin schützt der Fixiertropfen den von ihm abgedeckten Bereich vor möglichen äußeren Einflüssen wie z.B. auskondensierter Luftfeuchtigkeit. Bei Einsatztemperaturen unter 300°C und damit geringerem absolutem Ausdehnungsweg wird die mechanische Zugentlastung der Anschlussdrähte weniger wichtig.

Als Glasfixiertropfen werden in der Regel solche Fixiertropfen verstanden, die auf einer mineralischen Glaszusammensetzung basieren. Solche Glaszusammensetzungen nach dem Stand der Technik enthalten z. B. SiO₂, Al₂O₃, B₂O₃ und ZnO und enthalten nur geringe Mengen an Kohlenstoff. Insbesondere basieren Glasfixiertropfen nicht auf polymeren Verbindungen.

Für die Massenproduktion von passiven Bauelementen werden mehrere Strukturen auf einem gemeinsamen Substrat angeordnet, wobei mindestens ein Anschlussdraht an der jeweiligen Struktur mechanisch fixiert ist. Durch das Auftragen eines durchgängigen Fixiertropfens, welcher als durchgängige Schicht über mehrere Strukturen verläuft und diese zumindest anteilig bedeckt, wird der mindestens eine Anschlussdraht isoliert und in vielen Fällen auch zugentlastet. Das anschließende Vereinzeln der Bauelemente umfasst dann das Durchtrennen des Substrates und des Fixiertropfens.

Für das Vereinzeln der passiven Bauelemente stehen verschiedene Möglichkeiten zur Auswahl, wobei die passiven Bauelemente in der Regel durch Sägen, oder Laservereinzelung, oder Laserritzen und Brechen vereinzelt werden. Erfindungsgemäß soll die Vereinzelung nach dem Auftrag der Fixierung erfolgen. In einer bevorzugten Anwendung ist eine Vereinzelung durch den bereits aufgetragen und thermisch fertig prozessierten Fixiertropfen möglich. Alternativ ist es aber auch möglich, dass jedes später zu vereinzelnde Bauteil einen separaten Fixiertropfen hat, und die Vereinzelung zwischen diesen erfolgt. Diese Vorgehensweise des Sägens oder Laservereinzeln ist zwar mit einem Mehraufwand verbunden, insbesondere wenn die passiven Bauelemente ein hartes Substrat, z.B. auf Basis von Al₂O₃, umfassen, ist allerdings unabhängig von dem Fixiertropfen und dessen Ausformung anwendbar und mit geringen Ausfällen verbunden. Alternativ bietet sich die deutlich weniger arbeitsintensive und damit kostengünstigere Vereinzelung durch Brechen an. Diese Methode ist allerdings mit der Herausforderung verbunden, dass das Brechen von Glasfixiertropfen oftmals mit höheren Ausfallraten verbunden ist.

Da die meisten Fixiertropfen nicht definiert brechen, weisen Gläser, die nicht für diese Art der Vereinzelung optimiert wurden, schiefe Bruchflächen oder den Bruch an der falschen Stelle auf, also nicht durch die Sollbruchstelle im Substrat. Vorteilhaft dafür wäre daher ein Fixiertropfen, der die Zugspannungen, die beim Brechen auf die Fixierung wirken, so lange aushalten oder durch elastische Verformung ausgleichen kann, dass zuerst die Sollbruchstelle im Substrat bricht, die somit die Bruchposition in dem Fixiertropfen bestimmt.

Unter der Bruchfläche wird die durch die Vereinzelung neu entstandene Fläche eines passiven Bauteils verstanden. In diesem Zusammenhang sind beispielsweise Mikrorisse oder Abplatzungen an der Bruchfläche von Glasfixiertropfen als Risiken zu nennen. Weiterhin können die Mikrorisse auch in das Innere der Fixiertropfen propagieren, wobei diese nur schwer zu erkennen sind. Passive Bauteile mit solchen mangelhaft gebrochenen Fixiertropfen sind oft nicht für die weitere Verwendung geeignet. Noch schwerwiegender sind Schädigungen (wahrscheinliche Mikrorisse) im Inneren der Glasfixiertropfen, die durch den mechanischen Stress beim Brechen über den Drähten entstehen, wo der Fixiertropfen am dünnsten ist. Diese sind optisch nicht erkennbar und propagieren erst bei thermischer Belastung des Bauteils durch das Glasvolumen. Es zeigen sich dann feine Haarrisse über den Anschlussdrähten.

Aus dem Stand der Technik bekannte Glasfixiertropfen für Sensoren mit einer Einsatztemperatur bis 180°C sind porös und daher nur bedingt wasserdicht. Weiterhin können durch Wasser Mineral-Ionen aus den Glasfixiertropfen ausgewaschen werden, wodurch die Messwerte verfälscht werden.

Ein weiterer Nachteil, der sich bei der Verwendung von Glasfixiertropfen ergibt, ist, dass der Einbrand von Glastropfen äußerst energieintensiv ist, da Glasfixiertropfen bei 600 bis 700 °C über circa 15 Minuten eingebrannt werden. Diese hohen Temperaturen sind weiterhin nachteilig, da bei der Verwendung von preisgünstigen Nickeldrähten als Anschlussdrähte die Glühung von Glasfixiertropfen nur unter Schutzgas/Formiergas geleistet werden kann, wobei die Einstellung der Ofentemperaturen größere Spül- und Rüstzeiten erfordert. Auch die Verwendung von kunststoffummantelten Anschlussdrähten ist bei solch hohen Temperaturen nicht möglich.

Ebenso kann der Glasfixiertropfen beim Einbrennen verlaufen, wodurch die bedeckte Fläche bei der Wärmebehandlung größer wird. Da allerdings eine Mindestfixierhöhe des Glasfixiertropfen über den Anschlussdrähten erreicht werden muss, um einen vollständigen Umschluss der vorderen Bereiche der Anschlussdrähte zu gewährleisten, muss eine entsprechend größere Glasmenge aufgetragen werden. Unter vorderer Bereich des Anschlussdrahtes wird der Bereich verstanden indem Anschlussdraht in Kontakt mit dem Substrat ist.

Die oben beschriebenen Nachteile sind bei Glasfixiertropfen, die für die Vereinzelung durch Brechen optimiert wurden, noch gravierender, da das Einbrennen solcher brechbaren Glasfixiertropfen in der Regel bei hohen Temperaturen erfolgt und brechbare Glasfixiertropfen ein größeres Porenvolumen aufweisen als konventionelle Glasfixiertropfen.

Eine Möglichkeit, um zumindest die Anforderung an die Brechbarkeit zu umgehen, wäre, wie oben beschrieben, die Fixiertropfen nur punktuell an die Anschlussdrähte anzubringen, sodass das Durchbrechen der Fixiertropfen entfallen würde.

Die Aufgabe der vorliegenden Erfindung besteht darin, einen Fixiertropfen bereitzustellen, welche nach dem Aufbringen auf ein Substrat und der Inbetriebnahme des Bauteils eine Restelastizität besitzt. Insbesondere besteht die Aufgabe der vorliegenden Erfindung darin, einen Fixiertropfen, zur elektrischen Isolierung von Anschlussdrähten an passiven Baudelementen auf einem anorganischen Substrat, bereitzustellen, wobei die Wärmebehandlung bei niedrigeren Temperaturen erfolgen kann, wodurch eine breitere Materialauswahl für die Anschlussdrähte und deren optionale Ummantelung verfügbar gemacht wird.

Diese Aufgabe wurde überraschenderweise durch einen Fixiertropfen gemäß Anspruch 1 gelöst, nämlich einen Fixiertropfen, zur elektrischen Isolierung von Kontaktpads und den daran kontaktierten Anschlussdrähten an passiven Bauelementen, insbesondere Sensoren, vorzugsweise Temperatursensoren, auf einem anorganischen Substrat, insbesondere Metalloxid-, Halbleiter-, Metall-, und/oder Glassubstrat, dadurch gekennzeichnet, dass der Fixiertropfen eine hydrophobe Polymerzusammensetzung umfasst.

Hydrophobe oder wasserabweisende Polymerzusammensetzungen sind Polymerzusammensetzungen, die überwiegend aus mindestens einem hydrophoben Polymer gebildet sind, das in Wasser oder anderen polaren Lösungsmitteln unlöslich oder nur nahezu unlöslich ist. Beispielsweise können Acrylate, Epoxide, Polyethylen, Polyimide, Polystyrol, Polyvinylchlorid, Polytetrafluorethylen, Siloxane wie Polydimethylsiloxan, Polyester und Polyurethane als hydrophobe Polymere genannt werden.

Der erfindungsgemäße Fixiertropfen ist mit zahlreichen Vorteilen verbunden. So ist dieser Fixiertropfen zumindest wasserabweisend und zeigt eine minimale Rissbildung oder nicht lichtoptisch erkennbare Rissbildung bei der Vereinzelung der passiven Bauelemente durch Brechen, wodurch ein weiterer Verbau direkt im Anschluss danach machbar ist. Insbesondere kann die Herstellung von passiven Bauteilen energieeffizienter durchgeführt werden und die Anschlussdrähte und deren optionale Ummantelung können frei gewählt werden. Dies ist darauf zurückzuführen, dass der erfindungsgemäße Fixiertropfen bei deutlich niedrigeren Temperaturen wärmebehandelt werden kann als entsprechenden Glasfixiertropfen. Weiterhin ist ein eventueller Medieneinsatz wie Prozess- oder Inertgas bei solch niedrigen Temperaturen nicht nötig.

Ein weiterer Vorteil der polymerbasierten Fixiertropfen besteht im Auftreten einer Grenzfläche zwischen Abdeckschicht des thermosensitiven Elements, z.B. der Abdeckschicht des Mäanders, und des Polymers. Glasfixertropfen haften nach dem Fixiereinbrand in der Regel sehr gut an den darunterliegenden Glasschichten. Dagegen bleibt die Polymer-Glas-Grenzfläche diskret. Es findet keine Durchmischung des Polymers mit der angrenzenden Glasschicht statt. Dieser diskrete Grenzbereich fungiert als Rissbremse. Dadurch können sich im Fixiertropfen auftretenden Risse nicht bis über die Grenzfläche in die Abdeckschicht vordringen. Auftretende Spannungen beim Brechvorgang oder den anderen Produktionsschritten oder in der späteren Anwendung können im restelastischen Material abgebaut werden.

Durch die Restelastizität der Fixierung und den Fixiereinbrand bei im Vergleich zu Glas reduzierter Temperatur können bei größeren hergestellten Stückzahlen genauere Sollwiderstände mit einer geringeren Streuung erreicht werden. Die Elastizität ermöglicht weiterhin, dass der Fixiertropfen gebrochen und leicht bearbeitet oder unter leichter Druckspannung verbaut werden kann. Gleichzeitig weist der Fixiertropfen einen geringen Volumenanteil an Poren auf.

Auch passive Bauteile, deren Anschlussdrähte mit dem erfindungsgemäßen Fixiertropfen versehen wurden, haben den Vorteil, dass die Eigenerwärmung der passiven Bauteile geringer ist, wodurch Temperaturmessungen mit geringeren systematischen Fehlern möglich ist. Nachfolgend werden zahlreiche spezifische Details erörtert, um ein umfassendes Verständnis des vorliegenden Gegenstands zu ermöglichen. Es ist jedoch für den Fachmann offensichtlich, dass der Gegenstand auch ohne diese spezifischen Details praktiziert und nachgearbeitet werden kann.

Alle Merkmale einer Ausführungsform können mit Merkmalen einer anderen Ausführungsform kombiniert werden, wenn die Merkmale der verschiedenen Ausführungsformen vereinbar sind.

Die in der Beschreibung der vorliegenden Offenbarung verwendete Terminologie dient nur der Beschreibung bestimmter Ausführungsformen und ist nicht als Einschränkung des Gegenstands zu verstehen. Wie in der vorliegenden Beschreibung und den Ansprüchen verwendet, sind die Singularformen "ein", "eine" und "die" so zu verstehen, dass diese auch die Pluralformen einschließen, sofern der Kontext nicht eindeutig etwas Anderes vorgibt. Dies gilt auch umgekehrt, d.h. die Pluralformen schließen auch die Singularformen ein. Es versteht sich auch, dass der Begriff "und/oder", wie er hier verwendet wird, sich auf alle möglichen Kombinationen von einem oder mehreren der zugehörigen aufgelisteten Elemente bezieht und diese einschließt. Es versteht sich weiterhin, dass die Begriffe "beinhaltet", "einschließlich", "umfasst" und/oder "umfassend", wenn sie in der vorliegenden Beschreibung und den Ansprüchen verwendet werden, das Vorhandensein der angegebenen Merkmale, Schritte, Operationen, Elemente und/oder Komponenten spezifizieren, aber nicht das Vorhandensein oder Hinzufügen eines oder mehrerer anderer Merkmale, Schritte, Operationen, Elemente, Komponenten und/oder Gruppen davon ausschließen.

In der vorliegenden Beschreibung und den Ansprüchen können die Begriffe "beinhaltet", "umfasst" und/oder "umfassend" auch "bestehend aus" bedeuten, d.h. das Vorhandensein oder Hinzufügen eines oder mehrerer anderer Merkmale, Schritte, Operationen, Elemente, Komponenten und/oder Gruppen wird ausgeschlossen.

Besonders vorteilhaft ist es, den erfindungsgemäßen Fixiertropfen bis über einen Teil der Fläche der Abdeckschicht zu ziehen. Bei auftretenden Spannungen können zwar am Rand der Grenzfläche kleine Taschen entstehen, aber die spannungsführenden Teile, i.e. die Zuleitungsdrähte und die Kontaktpads, bleiben weiter vollständisch elektrisch isoliert und vor Luftfeuchte geschützt.

In einer speziellen Ausführung kann auch mindestens 80 % der Sensorfläche oder die komplette Sensorfläche vom erfindungsgemäßen Fixiertropfen bedeckt sein.

In einer weiteren speziellen Ausführungsform ragt der erfindungsgemäße Fixiertropfen weniger als 10%, bevorzugt weniger als 5%, besonders bevorzugt weniger als 3%, der Sensorlänge, über die Substratfläche hinaus.

In einer anderen gängigen Ausführung bleibt die zweite Seite des Substrates im Wesentlichen frei vom Material des Fixiertropfens. Dadurch ist eine automatisierte Produktion ganzer Sensorzeilen vor dem Trennvorgang der Einzelelemente erleichtert.

Explizit besteht die erfindungsgemäße Ausführung aus einem Sensorelement mit Fixiertropfen, das noch nicht in einer weiteren Hülle eingepasst oder befestigt ist. Das erfindungsgemäße Sensorelement ist daher nicht primär gehaust.

Ein späteres Anbringen eines zusätzlichen Gehäuses ist jedoch möglich. Zudem ist der Verbau in ein Gehäuse auch möglich, ohne den erfindungsgemäßen Fixiertropfen vorher zu demontieren.

Der erfindungsgemäße Fixiertropfen zur elektrischen Isolierung von Anschlussdrähten befindet sich vorzugsweise dergestalt auf der Struktur, dass die Kontaktpads für die Anschlussdrähte bedeckt sind.

Weiterhin ist es vorteilhaft, dass die Mäanderfläche zu 10 bis 80%, vorzugsweise zu 10 bis 60%, besonders bevorzugt zu 20 bis 50% mit dem erfindungsgemäßen Fixiertropfen bedeckt ist.

Der erfindungsgemäße Fixiertropfen ist zumindest wasserabweisend und gewährleistet einen gewissen Schutz vor Feuchtigkeit. Fixiertropfen auf Basis von z.B. Silikonen oder Polyimiden sind zudem hydrophob, was die Beständigkeit gegen Wasserdurchflutung oder das Auflösen in Wasser erhöhen kann. Außerdem kann das Auslaugen von Mineralien, wie es bei Bor in Glasfixiertropfen vorkommt, verhindert werden.

Der erfindungsgemäße Fixiertropfen ist daher vorzugsweise dadurch gekennzeichnet, dass die Polymerzusammensetzung mindestens ein Silikon, bevorzugt Flüssig-Silikon-Kunststoff oder Polyimide, insbesondere Einkomponenten-Polymere umfasst.

Vorzugsweise ist die hydrophobe Polymerzusammensetzung des erfindungsgemäßen Fixiertropfen im Wesentlichen frei von Fluorverbindungen und erfüllt somit die Verordnung der EU 2021/1297 bezüglich PFAS-Konzentrationen.

Ein weiterer Vorteil der sich bei der bevorzugten Verwendung von Silikon als Polymerzusammensetzung ergibt, ist, dass der Schrumpf im Herstellungsprozess in der Regel geringer als bei einem vergleichbar großen Glasfixiertropfen ist. Hierdurch können die Anschlussdrähte im Schaftbereich an einem passiven Bauelement besser umschlossen werden.

Der Schrumpf bei den beiden Fixiertropfen beruht allerdings auf unterschiedlichen Prozessen. Glasfixiertropfen und Glaskeramikfixiertropfen schrumpfen aufgrund des Wasser -oder Lösungsmittelverlustes bei den Brennvorgängen. Silikonwerkstoffe schrumpfen in erster Linie aufgrund der chemischen Polymerisationsreaktion. Mit dem Schrumpf geht eine Volumenverkleinerung einher.

Besonders vorteilhaft sind Fixiertropfen, die mit Füllstoffen gefüllt sind, deren Ausdehnungskoeffizient nahe am oder größer als der Wärmeausdehnungskoeffizient des Substrats ist, da solche gefüllten Fixiertropfen auch bei schnellen Temperaturwechseln frei von Rissen bleiben. Ebenso ist auch die Verwendung von Mineral-, Glas- oder Kunststofffasern denkbar.

Ein weiter Vorteil der gefüllten Polymerzusammensetzung, insbesondere einer Polymerzusammensetzung die mit anorganischen Füllstoffen gefüllt ist, ist der geringe Schrumpf beim Anbringen und Aushärten des Fixiertropfens. Die gefüllten Polymerzusammensetzungen besitzen bereits beim Aushärten einen geringeren Schrumpf, was an der Grenzfläche zwischen Abdeckschicht und Fixiertropfen auftretende Spannungen minimiert.

Grundsätzlich können sich bei Substraten mit niedrigen Ausdehnungskoeffizienten, insbesondere bei Ausdehnungskoeffizienten, die niedriger sind als die Ausdehnungskoeffizienten des Fixiertropfens sind, die Schrumpfspannungen vom Aushärten und die thermischen Spannungen aus den Temperaturwechseln addieren. Dies gilt insbesondere für Substrate mit einem Ausdehnungskoeffizienten von kleiner als 16 × 10⁻⁶ K, gemessen bei einem Temperaturbereich von 0 bis 100°C.

Vorteilhaft ist auch eine Füllung des Fixiertropfens, wobei der Unterschied in den Ausdehnungskoeffizienten zwischen der Füllung des Fixiertropfens und der Polymermatrix des Fixiertropfens kleiner 6 × 10⁻⁶ K, insbesondere kleiner als 4 × 10⁻⁶ K sind. In diesem Fall ist die Gefahr geringer, dass der Tropfen bei Temperaturwechseln aufgrund innerer Spannungen aufreißt. Metalloxide mit hohen Ausdehnungskoeffizienten sind auch in EP1072569B1 beschrieben.

Mögliche Verunreinigungen oder das Auftreten von Polarisationseffekten in den Mineralien beeinträchtigt die Funktion des Füllstoffes nicht maßgeblich, da der Füllstoff von der Matrix des erfindungsgemäßen Fixiertropfen umgeben ist.

Die erfindungsgemäße Fixiertropfen ist vorzugsweise dadurch gekennzeichnet, dass die Polymerzusammensetzung mindestens einen partikelförmigen Füllstoff ausgewählt aus der Gruppe bestehend aus Oxidkeramiken, Nitriden und Carbiden, besonders bevorzugt SiO₂, Al₂O₃, SiN, SiC, TiO₂, MgO, ZrO₂, oder Mischoxide daraus oder andere Metallnitride, oder Gläser umfasst, und/oder der Füllstoff eine Partikelgrößenverteilung mit einem D₅₀ von kleiner als 50 µm, insbesondere mit einem D₅₀ kleiner 5 µm, besonders bevorzugt von 0,8 µm bis 1,3 µm, ermittelt durch Laserdiffraktion, aufweist.

Der mindestens eine partikelförmige Füllstoff kann ebenso Mischungen aus verschiedenen Füllstoffen oder Füllstoffen mit verschiedenen Partikelgrößenverteilungen umfassen.

Der Ausdehnungskoeffizient der Polymerzusammensetzung und vorzugsweise auch die Wärmeleitfähigkeit der Polymerzusammensetzung können an die Umgebung oder die nächstgelegenen Teile des passiven Bauteils angepasst werden. Die Füllung kann auch so gewählt werden, dass der Ausdehnungskoeffizient entsprechend größer ist als der Ausdehnungskoeffizient des Substrats.

Der erfindungsgemäße Fixiertropfen ist daher vorzugsweise dadurch gekennzeichnet, dass der Ausdehnungskoeffizient der Polymerzusammensetzung größer ist als der Ausdehnungskoeffizient des Substrates und/oder der Anschlussdrähte und/oder der Kontaktpads.

Diese Eigenschaft ist insbesondere bei der bevorzugten Verwendung als Fixiertropfen auf einem passiven Bauelement vorteilhaft, da der erfindungsgemäße Fixiertropfen vorzugsweise in Zeilen auf passive Bauelemente aufgetragen wird, welche durch Brechen vereinzelt werden. Ein thermisches Ausheilen des erfindungsgemäßen Fixiertropfens ist nach dem Brechen nicht notwendig, da keine kritischen, transportstoßempfindlichen Risse im Silikonmaterial verbleiben.

Der erfindungsgemäße Fixiertropfen ist ferner vorzugsweise dadurch gekennzeichnet, dass der mindestens eine Füllstoff in einer Menge von 3 bis 60 Gew.-%, vorzugsweise von 5 bis 13 Gew.-%, besonders bevorzugt von 7 bis 11 Gew.-%, bezogen auf die Gesamtmasse des Fixiertropfens, vorliegt.

Da es sich bei dem erfindungsgemäßen Fixiertropfen um ein inhomogenes Gemisch handeln kann, beziehen sich die angegebenen Gew.-% auf den jeweils durchschnittlichen Gehalt in dem Fixiertropfen. Lokale Abweichungen der Gew.-% in dem Fixiertropfen sind möglich, gleichen sich aber zu den angegebenen Gew.-% aus.

Vorzugsweise wird der Füllstoff im erfindungsgemäßen Fixiertropfen aus MgO und Al₂O₃ ausgewählt, da diese Füllstoffe eine geringe Ausdehnungsfehlanpassung zum Substrat aufweisen. Die Differenz der Wärmeausdehnungskoeffizienten zwischen Füllstoff und Substrat beträgt bevorzugt zwischen + 30% und -20%, weiter bevorzugt zwischen +15 und-5%, noch weiter bevorzugt zwischen 10% und 0% Die Fehlanpassung soll insbesondere gemessen werden von 20°C zur Einsatztemperatur des Sensors. Bei silikonbasierten Fixiertropfen liegt der empfohlene Temperaturbereich von -50°C bis 150°C.

Insbesondere wird Al₂O₃ bevorzugt, da dieser Füllstoff in besonders hohen Mengen von bis zu 60 Gew.-%, bezogen auf die Gesamtmasse des Fixiertropfens, in den erfindungsgemäßen Fixiertropfen eingebracht werden kann.

Im Gegensatz zu Glasfixiertropfen hat der erfindungsgemäße Fixiertropfen vorzugsweise ein geringes Volumen an Poren bzw. zeigt keine offene Porosität, wodurch ein Eindringen von Wasser weitestgehend vermieden werden kann. Hierdurch kann auch bei dem Vorliegen von oberflächlichen Rissen kein Wasser bis zu den Anschlussdrähten vordringen. Weiterhin wird auch der Transport von möglicherweise vorliegenden Ionen unterbunden und somit keine unerwünschte Offsetspannung erzeugt.

Der erfindungsgemäße Fixiertropfen ist ferner vorzugsweise dadurch gekennzeichnet, dass der Fixiertropfen weniger als 35 Vol.-%, vorzugsweise weniger als 25 Vol.-%, bevorzugt weniger als 15 % an Poren aufweist, und/oder keine offene Porosität zeigt.

Vorzugsweise weist der erfindungsgemäße Fixiertropfen eine Härte von 75 bis 95 Shore A, vorzugsweise von 80 bis 95 Shore A, gemessen mit einem Shore-Härteprüfer A Handgerät, auf.

Die vorliegende Erfindung betrifft ferner ein passives Bauelement, insbesondere Sensor, vorzugsweise Temperatursensor.

Die vorliegende Erfindung betrifft ferner ein passives Bauelement, insbesondere Sensor, vorzugsweise Temperatursensor, oder Heizer, umfassend Anschlussdrähte und ein anorganisches Substrat, insbesondere Metalloxid-, Halbleiter- und/oder Glassubstrat oder ein Metallsubstrat, insbesondere Stahlsubstrat, mit mindestens einer Isolationsschicht oder intrinsischer Isolationsschicht.

Die vorliegende Erfindung betrifft ferner ein passives Bauelement, insbesondere Sensor, vorzugsweise Temperatursensor, umfassend Anschlussdrähte und ein anorganisches Substrat, insbesondere Metalloxid-, Halbleiter- und/oder Glassubstrat, oder Polymersubstrat dadurch gekennzeichnet, dass die Anschlussdrähte durch den aufgetragenen erfindungsgemäßen Fixiertropfen elektrisch isoliert sind.

Weiterhin ist es bevorzugt, dass das anorganische Substrat derartig ausgewählt ist, dass es an den Ausdehnungskoeffizienten des erfindungsgemäßen Fixiertropfens angepasst ist.

In einer bevorzugten Ausführungsform des erfindungsgemäßen passiven Bauelements ist das Substrat ein mehrschichtiges Substrat aus mehreren übereinander angeordneten Schichten, wobei die Schichten anorganische Stoffe und/oder Kunststoffe umfassen.

Zudem ist bevorzugt, dass die Ausdehnung des Polymerfixiertropfen angepasst ist auf den Ausdehnungskoeffizienten der obersten Schicht der Kontaktpads und die verwendeten Anschlussdrähte.

Ein weiterer Vorteil bei der Verwendung des erfindungsgemäßen Fixiertropfens zur elektrischen Isolation der Anschlussdrähte eines passiven Bauelements ist der geringe Materialbedarf und damit die Möglichkeit, flachere passive Bauelemente bei gleicher Dicke der Anschlussdrähte und des Substrats herzustellen. Glasfixiertropfen müssen eine relativ große Höhe aufweisen, damit der Glasfixiertropfen beim Vereinzeln an der richtigen Stelle bricht. Aus diesem Grund können Fixiertropfen aus Glas eine Dicke von bis zu 1,2 mm über den Anschlussdrähten erreichen. Im Gegensatz zu passiven Bauelementen, die mit einem Glasfixiertropfen zugentlastet und elektrisch isoliert wurden, die oftmals eine Erhebung zwischen den Anschlussdrähten aufweisen, können passive Bauelemente, die mit dem erfindungsgemäßen Fixiertropfen elektrisch an der Kontaktstelle isoliert wurden, eine Vertiefung zwischen den Anschlussdrähten aufweisen.

Das erfindungsgemäße passive Bauelement ist ferner vorzugsweise dadurch gekennzeichnet, dass die Kontaktpads und die daran kontaktierten Anschlussdrähte durch einen Fixertropfen elektrisch isoliert sind, wobei vorzugsweise das komplette Bauteil über den Anschlussdrähten eine Höhe von kleiner als 0,8 mm, bevorzugt kleiner als 0,75 mm, besonders bevorzugt kleiner als 0,7 mm, aufweist.

Als Höhe wird die gesamte Höhe des erfindungsgemäßen passiven Bauelements einschließlich des Substrats verstanden.

Das Vereinzeln durch Brechen hat sich als besonders wirtschaftliches Verfahren für passive Bauelemente, deren Anschlussdrähte mit einem Glasfixiertropfe zugentlastet sind, etabliert. Bei dieser Trennmethode hat es sich als vorteilhaft erwiesen, wenn Sollbruchstellen im Substrat vorhanden sind und somit ein einfaches Brechen, insbesondere bei harten Substraten, möglich ist.

Das erfindungsgemäße passive Bauelement ist ferner vorzugsweise, dadurch gekennzeichnet, das passive Bauelement durch Vereinzelung erhalten wurde, wobei das Vereinzeln vorzugsweise ein Brechen, insbesondere an mindestens einer Sollbruchstelle, und/oder Sägen, umfasst.

Auch wenn aus prozessökonomischer Sicht, dass Vereinzeln durch Brechen dem Sägen vorzuziehen ist, ist es mit einigen Herausforderungen verbunden geeignete Fixiertropfen bereitzustellen, welche für diese Methode geeignet sind. Insbesondere das Auftreten von kritischer Rissbildung lässt sich mit dem erfindungsgemäßen Fixiertropfen vermeiden.

Das erfindungsgemäße passive Bauelement ist ferner vorzugsweise, dadurch gekennzeichnet, dass der Fixiertropfen keine kritische Rissbildung bei der Vereinzelung der passiven Bauelemente aufweist.

Im Sinne der vorliegenden Erfindung wird die Rissbildung anhand der Schnittwinkel charakterisiert. Beim Vereinzeln der passiven Bauelemente werden mindestens zwei passive Bauelemente durch Brechen voneinander getrennt. Die sich hierdurch gebildete Bruchfläche an einem der passiven Bauelement ist idealerweise senkrecht zur Substratebene, sodass die vier Schnittwinkel zwischen Bruchfläche und Substratebene alle 90° betragen. Da sich Nebenwinkel zu 180° ergänzen, ist es nicht nötig alle Winkel zu berücksichtigen, sondern die Qualifizierung der Rissbildung kann über die Angabe des kleinsten Schnittwinkels erfolgen. Unter realen Bedingungen brechen die passiven Bauelemente allerdings nicht ideal, sondern es kann zu erheblichen Abweichungen kommen. Diese Abweichungen sind tolerierbar, solange die Abmaße des passiven Bauelements sicher innerhalb der vorgegebenen Toleranzen liegen.

Unter kritischer Rissbildung wird daher verstanden, dass der kleinste Schnittwinkel zwischen der Bruchfläche und der Substratebene des passiven Bauelements weniger als 45° beträgt.

Es ist daher bevorzugt, dass der kleinste Schnittwinkel zwischen der Bruchfläche und der Substratebene des passiven Bauelements über 45°, bevorzugter 60°, weiter bevorzugt über 70° beträgt.

Unter Mikrorissen werden feine Risse in dem Fixiertropfen zusammengefasst, die nur schwierig zu erkennen sind. Diese Mikrorisse können beim Brechen der Fixiertropfen auftreten und werden beispielsweise durch optische Kontrolle nach Abschluss der Herstellung und Vereinzelung der passiven Bauelemente erkannt.

Der Erfindungsgemäße Fixiertropfen hat nicht nur eine geringere Härte als Glasfixiertropfen, sondern besitzt auch Restelastizität. Nach der Polymerisation ist der Polymer-Werkstoff allein und auch ein erfindungsgemäßer pulvergefüllter Werkstoff noch elastisch verformbar. Diese Elastizität kann mit der Lagerzeit und der Alterung durch vielfache Temperaturwechsel abnehmen. Bei wenigen Wochen alten Bauteilen mit geringer Anzahl von Temperaturwechseln ist die Restelastizität jedoch vorhanden.

Ein besonderer Vorteil in der Restelastizität der nur gering gealterten Fixiertropfen ist die leichte Verbaubarkeit insbesondere in engen Gehäusen oder Röhren. Ein Quetschen oder Abreiben der Kante des Fixiertropfens trägt kaum zur weiteren Rissbildung nach dem Vereinzeln bei. Vielmehr können so sogar Formüberstände des Fixertropfens bereinigt werden.

Eine Nachbearbeitung unter Materialabtrag, ein Zuschneiden in eine Form, insbesondere eine Kantennachbearbeitung des Fixiertropfens durch Ziehen durch ein Kaliber ist sowohl händisch als auch automatisiert möglich. Aufgrund der zu erwartenden sehr geringen Ausfallquote der robusten Fixierung ist hier sogar die automatische Nachbearbeitung möglich. Selbst ein Einbau in eine enge Umgebung unter kratzendem Schaben am Fixiertropfen ist möglich. Insbesondere löst auch ein Einbau und der bestimmungsgemäße Temperaturwechsel keine kritische Rissbildung aus, die durch den kompletten Fixiertropfen und noch schlimmer weiter in die Abdeckschicht des Mäanders propagieren kann.

Weiterhin ist es möglich und nicht grundsätzlich nachteilig, wenn der restelastische Fixiertropfen unter Druck- oder Zugspannung verbaut wird. Dies ist ein Vorteil, wenn das passive Bauelement in enge Röhren oder in der Nähe von Wandungen oder anliegend an schroffen Oberflächen eingebaut werden soll.

Außerdem ermöglicht die Restelastizität des Fixiertropfens ein spannungsarmes Umspritzen des passiven Bauelements. Dabei werden die elektrischen Kennwerte nur in geringem Maße, innerhalb der Spezifikation, verändert. Insbesondere bei Platin-Dünnschicht-Temperatursensoren bleiben die zuvor eingestellten Toleranzwerte des Temperaturkoeffizienten (TK) und des Sollwiderstandes (Ro) innerhalb der Güteklasse 1/3 DIN (AA) erhalten.

Das erfindungsgemäße passive Bauelement ist vorzugsweise dadurch gekennzeichnet, dass das passive Bauelement eine Eigenerwärmung von weniger als 0,4 K/mW, bevorzugt von weniger 0,35 K/mW, besonders bevorzugt 0,3 K/mW, aufweist.

Eine geringere Eigenerwärmung des passiven Bauelements hat den Vorteil, dass Messungen im stationären Zustand mit einem geringeren systematischen Fehler präziser durchgeführt werden können.

Als Anschlussdrähte für die passiven Bauelemente können Zuleitungsdrähten aus Nickel oder besser lötbarem silberummantelten Nickel oder alle anderen üblichen Materialien wie Gold oder platinummanteltes Nickel oder Platindrähte verwendet werden. Im Gegensatz zu Glasfixiertropfen ist der erfindungsgemäße Fixierprozess kompatibel mit diversen Kunststoffen, sodass auch mit Kunststoff ummantelte Anschlussdrähte für die passiven Bauelemente verwendet werden können, wobei die ummantelten Anschlussdrähte im Kontaktbereich abisoliert sein müssen.

Das erfindungsgemäße passive Bauelement ist vorzugsweise, dadurch gekennzeichnet, dass die Anschlussdrähte Nickel- oder Kupferdraht, optional mit Kunststoff-, Silber- oder Platinmantel umfassen.

Die Anschlussdrähte können anstelle einer Ummantelung auch mit einer Beschichtung versehen werden, solange diese mit dem erfindungsgemäßen Fixiertropfen kompatibel ist.

Vorzugsweise wird der erfindungsgemäße Fixiertropfen dergestalt auf die Kontaktpads aufgetragen, dass die Anschlussdrähte bedeckt sind. Optional kann der erfindungsgemäße Fixiertropfen auch den nicht abisolierten Bereich der ummantelten Anschlussdrähte teilweise abdecken. Insbesondere bei der bevorzugten Verwendung von Kunststoff als Ummantelung für die Anschlussdrähte ist es vorteilhaft, dass der Kunststoff an der sensorzugewandten Seite bis in den erfindungsgemäßen Fixiertropfen hineinragen kann.

Das erfindungsgemäße passive Bauelement ist ferner vorzugsweise, dadurch gekennzeichnet, dass die Anschlussdrähte Nickeldraht mit einem Kunststoffmantel umfassen, wobei der Kunststoff vorzugsweise aus Glasfaser, Silikone, Teflon, PEEK, Polyurethan, Kresole, Polyimide, Polyesterimide, PMA, PMAA, oder Viton oder gefülltem Kunststoff ausgewählt ist, und der Kunststoffmantel am Anschlussdraht vor dem Auftragen des Fixiertropfen befestigt wurde und/oder in den Fixiertropfen hineinragt.

Das erfindungsgemäße passive Bauelement ist ferner vorzugsweise, dadurch gekennzeichnet, dass das passive Bauelement ein Temperatursensor ist, der die Gültigkeit der Toleranzklasse F 0.3 (B) bei einer Temperatur von -20 bis 130°C einhält.

Weitere bevorzugte Ausgestaltungen des erfindungsgemäßen passiven Bauelements erfüllen die Toleranzklasse F0.3 (B) bei einer Temperatur von -20 bis 270°C.

Besonders bevorzugt ist das erfindungsgemäße passive Bauelement ein Pt-Temperatursensor, welcher die Güteklasse 1/3 DIN (AA) erfüllt. Dies gilt sowohl für unbenutzte Pt-Temperatursensoren als auch nach einem Auslagerungstest bei 85°C und 85% Luftfeuchtigkeit für 1000 Stunden.

Die vorliegende Erfindung betrifft ferner ein Verfahren zur Herstellung von passiven Bauelementen, insbesondere zur Herstellung des erfindungsgemäßen passiven Bauelements.

Das Verfahren umfasst die folgenden Schritte, wobei die im Folgenden zitierte Reihenfolge der einzelnen Schritte nicht zwingend ist
- Bereitstellen eines anorganischen Substrats, insbesondere eines Metalloxid- oder Halbleitersubstrats oder eines Glassubstrats, auf dem mehrere Strukturen, insbesondere in Reihe, angeordnet sind,
- optional Ausbilden von Sollbruchstellen in dem anorganischen Substrat zwischen den Strukturen, insbesondere mittels eines Lasers und/oder mittels mechanischer Abtragung,
- Anbringen von mindestens einem Anschlussdraht an jedem der Kontaktpads der Strukturen,
- Bedecken der Kontaktpads und der Spitzen der Anschlussdrähte durch Aufbringen einer Polymerpaste, insbesondere der erfindungsgemäßen Polymerzusammensetzung,
- Wärmebehandlung der Polymerpaste, insbesondere bei einer Temperatur von 120 bis 375 °C, bevorzugt von 120°C bis 300°C, noch bevorzugter von 140 bis 220 °C, um einen Fixiertropfen, insbesondere den erfindungsgemäßen Fixiertropfen, zu erhalten
- Abkühlen des Fixiertropfens auf eine Temperatur bei der der Fixiertropfen formstabil ist, vorzugsweise auf Raumtemperatur
- Vereinzelung der passiven Bauelemente, insbesondere durch das Brechen des anorganischen Substrats an den Sollbruchstellen.

Gegebenenfalls müssen die Kanten des Fixiertropfens nach dem Herstellungsprozess mechanisch nachbearbeitet werden, was zu einem Materialverlust führen kann.

Das so hergestellte passive Bauelement, insbesondere das erfindungsgemäße passive Bauelement, kann unter mechanischer Belastung, die bereits bei Raumtemperatur auf den Fixiertropfen einwirkt, eingebaut und der elektrische Widerstand gemessen werden oder an rauen Oberflächen angebracht werden. Fixiertropfen haben im Allgemeinen einen höheren Ausdehnungskoeffizienten als das angrenzende Substrat oder als die Anschlussdrähte aus Platin. Daher stehen die Fixiertropfen auch bei Raumtemperatur unter Zugspannung und dehnen sich bei Temperaturerhöhung stärker aus. Dadurch nimmt die Zugspannung des Fixiertropfens ab und das passive Bauelement wird stabiler. Ein weiterer Vorteil ist, dass die Spannung auf den Mäander bei höheren Temperaturen geringer ist.

Da das erfindungsgemäße Verfahren eine Wärmebehandlung deutlich niedrigere Temperaturen vorsieht als Verfahren zur Herstellung von passiven Bauelementen gemäß dem Stand der Technik, welche regelmäßig eine Temperatur von bis zu 600 bis 700°C oder darüber hinaus für die Wärmebehandlung benötigen, können erheblich Mengen an Energie eingespart werden.

Weiterhin kommt es bei solch niedrigen Temperaturen nicht zu ungewünschten Nebenreaktionen, sodass neben Luftzutritt keine Spülung mit Prozess- bzw. Formiergas nötig ist. Folglich entfallen hierdurch auch lange Rüstzeiten bzw. Vorspülzeiten mit Prozessgas des Prozessofens bei der Wärmebehandlung des Fixiertropfens.

Auch die Materialauswahl für die Anschlussdrähte und deren optionalen Ummantelung ist bei solch niedrigen Temperaturen deutlich größer, insbesondere kann auf teure platinummantelte Anschlussdrähte verzichtet werden. Da zum Beispiel Anschlussdrähte aus Nickel nicht zu Nickeloxid oxidieren, können auch deutlich günstigere reine Nickeldrähte, die optional mit Kunststoff ummantelt sind, verwendet werden.

Ebenso können silberummantelte Anschlussdrähte aus Nickel verwendet werden, die aufgrund ihrer besseren Lötbarkeit bevorzugt sind, ohne dass eine komplexe Prozessführung mit engen Prozessfenstern unter Formiergas nötig ist.

Bevorzugten Ausgestaltungen des vorstehend beschriebenen Verfahrens umfassen, in Abhängigkeit der Zusammensetzung der Polymerpaste und des verwendeten Materials für die Anschlussdrähte und optionalen Ummantelungen, alternative Temperaturbereiche für die Wärmebehandlung.

In einer bevorzugten Ausführungsform des erfindungsgemäßen Verfahrens sind die Schritte wie folgt ausgestaltet:
- Bereitstellen eines anorganischen Substrats, insbesondere eines Metalloxid- oder Halbleitersubstrats oder eines Glassubstrats, auf dem mehrere Strukturen, insbesondere in Reihe, angeordnet sind,
- Ausbilden von Sollbruchstellen in dem anorganischen Substrat zwischen den Strukturen, insbesondere mittels eines Lasers und/oder mittels mechanischer Abtragung,
- Anbringen von mindestens einem Anschlussdraht an jedem der Strukturen,
- Bedecken der Anschlussdrähte durch Aufbringen einer Polymerzusammensetzung die ein Silikon, bevorzugt Flüssig-Silikon-Kunststoff, insbesondere Einkomponenten-Polymere, umfasst, über die mehreren Strukturen,
- Wärmebehandlung der Polymerzusammensetzung bei einer Temperatur von 120 bis 300 °C, bevorzugt 120°C bis 220°C um eine bevorzugte Ausführungsform des erfindungsgemäßen Fixiertropfen zu erhalten
- Abkühlen des Fixiertropfens auf eine Temperatur bei der der Fixiertropfen formstabil ist
- Vereinzelung der passiven Bauelemente durch das Brechen des anorganischen Substrats und des durchgängigen Fixiertropfens an den Sollbruchstellen.

Da die Lötbarkeit von Anschlussdrähte aus Nickel durch eine Silberummantelung verbessert werden kann, ist diese alternative Ausführungsform für bestimmte Anwendungen vorteilhaft. Vorteilhafterweise kann in dem nachfolgenden Verfahren auf die Zugabe von Formiergas verzichtet werden, wobei die Oxidation von Silber unterbleibt, sodass die Lötbarkeit der Anschlussdrähte erhalten bleibt.

In einer weiteren bevorzugten Ausführungsform des erfindungsgemäßen Verfahrens sind die Schritte wie folgt ausgestaltet:
- Bereitstellen eines anorganischen Substrats, insbesondere eines Metalloxid- oder Halbleitersubstrats oder eines Glassubstrats, auf dem mehrere Strukturen, insbesondere in Reihe, angeordnet sind,
- Ausbilden von Sollbruchstellen in dem anorganischen Substrat zwischen den Strukturen, insbesondere mittels eines Lasers und/oder mittels mechanischer Abtragung,
- Anbringen von mindestens einem Anschlussdraht, wobei die Anschlussdrähte Nickeldraht mit Silbermantel umfassen, an jedem der Strukturen,
- Bedecken der Anschlussdrähte durch Aufbringen einer Polymerzusammensetzung die Polyimide, insbesondere Einkomponenten-Polymere, umfasst, über die mehreren Strukturen,
- Wärmebehandlung der Polymerzusammensetzung bei einer Temperatur von 325 bis 400 °C, insbesondere von 350 bis 375 °C, um eine bevorzugte Ausführungsform des erfindungsgemäßen Fixiertropfen zu erhalten,
- Abkühlen des Fixiertropfens auf eine Temperatur bei der der Fixiertropfen formstabil ist, vorzugsweise auf Raumtemperatur
- Vereinzelung der passiven Bauelemente durch das Brechen des anorganischen Substrats und des durchgängigen Fixiertropfens an den Sollbruchstellen.

Die Reihenfolge der Schritte für die vorstehend aufgelisteten Verfahren ist nicht zwingend, sondern umfasst ferner alle technisch sinnvollen Reihenfolge. Es wäre zum Beispiel möglich die Sollbruchstellen erst nach dem Auftragen Aufbringen einer durchgängigen Polymerpaste auszubilden.

In einer bevorzugten Ausgestaltung des erfindungsgemäßen Verfahrens werden die Verfahrensschritte in der aufgelisteten Reihenfolge ausgeführt.

Alle bevorzugten Ausführungsformen und Definitionen für die erfindungsgemäßen passiven Bauelemente gelten analog für das erfindungsgemäße Verfahren.

Die vorliegende Erfindung betrifft ferner ein passives Bauelement erhältlich nach dem vorstehend beschriebenen Verfahren.

Die vorliegende Erfindung betrifft zudem die Verwendung eines Fixiertropfens, wie vorstehend beschrieben, zur Isolation von Kontaktpads und Anschlussdrähten an passiven Bauelementen, insbesondere wie vorstehend beschrieben oder erhältlich nach den vorstehend beschriebenen Verfahren.

In einer bevorzugten Ausgestaltung der erfindungsgemäßen Verwendung wurden die passiven Bauelemente durch Vereinzelung erhalten, wobei das Vereinzeln ein Brechen, insbesondere an Sollbruchstellen, umfasst.

Die vorstehend für den erfindungsgemäßen Fixiertropfen und das erfindungsgemäße passive Bauelement aufgeführten bevorzugten Ausführungsformen gelten auch für das erfindungsgemäße Verfahren, das mit diesem Verfahren erhaltenen passive Bauelement und die Verwendung der Fixiertropfen.

Die Erfindung wird nachfolgend anhand von nicht beschränkenden Beispielen näher erläutert.

### Beschreibung der Figuren

Figur 1 zeigt eine Vergleichsmessung der Eigenerwärmung von vier passiven Bauelementen bei gleicher angelegter Spannung.
Figur 2: zeigt die Ergebnisse eines Auslagerungstests für eine Serie von 10 erfindungsgemäßen Platin-Temperatursensoren des Nominalwiderstandes von 1000 Ohm (Pt1000 Elemente). Als Drift ist die Differenz in der im selben Bauteil angezeigten Temperaturen bei 0°C vor und nach dem Auslagerungstest aufgetragen.

### Beispiele

### Beispiel 1:

Es wurden vier passive Bauelemente mit den gleichen Al2O3 Substraten, Abdeckschichten aus Gläsern, gleichen Pt-Anschlussdrähten und Geometrien und Widerständen bereitgestellt. Die Herstellung fand im identischen Produktionszyklus statt. Die Anschlussdrähte von zwei passiven Bauelementen wurden mit jeweils handelsüblichen Glasfixiertropfen, und die Anschlussdrähte der anderen zwei passiven Bauelemente wurden mit jeweils den erfindungsgemäßen Silikon Fixiertropfen bedeckt und damit elektrisch isoliert.

Der Precursordispersion für die Silikonfixiertropfen wurden gemischt aus 71% Locktite SI 5091 LC von Henkel, 20% Al₂O₃ Pulver der Korngröße D 50 = 0,8-1,3 µm, und 9% Hydrolyseprodukt von Trimethoxyoctyl-silan und Siliziumdioxidpulver, (Silan, Trimethoxyoctyl-, Hydrolyseprodukte mit Siliciumdioxid CAS 92797-60-9). Die Angaben sind in Gewichtsprozent. Diese Dispersion wurde mit einer Spritze händisch dünn auf die vorbereiteten Sensorreihen aufgetragen und unter einer Amba^{®} UV-Härtungslampe der Heraeus Noblelight für 1 Minute gehärtet und 3 Tage bei Raumtemperatur ausgelagert. Danach erfolge eine Teilung der Zeilen in einzelne Sensoren.

Die vier so hergestellten passiven Bauelemente wurden bezüglich ihrer Eigenerwärmung getestet. Dabei wurden die Bauteile parallelgeschaltet und mit erhöhter Spannung beaufschlagt, so dass sich ein Strom höher des üblichen Messtroms ergab und eine deutliche Erwärmung in allen Bauteilen hier bis über 55°C einstellte.

Die Messungen fanden unter Luft, bei Raumtemperatur statt, wobei für alle Messungen dieselbe Spannung an den passiven Bauelementen angelegt wurde.

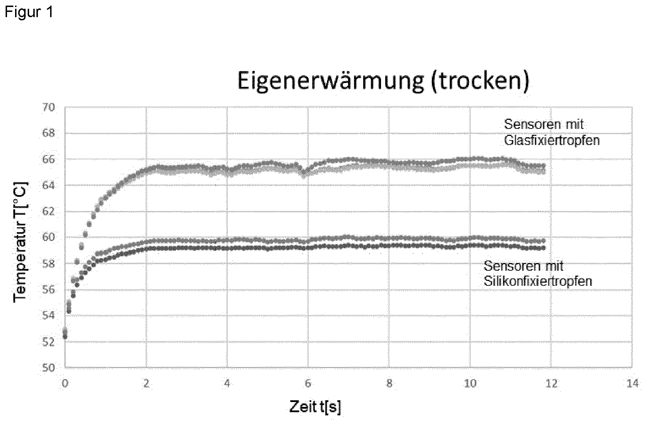

Die Messergebnisse sind in Figur 1 dargestellt.

Es ergab sich, dass die passiven Bauelemente, welches mit dem Glasfixiertropfen zugentlastet und elektrisch isoliert wurden, eine Eigenerwärmung von 0,4 K/mW aufwiesen.

Im Gegensatz dazu betrug die Eigenerwärmung der passiven Bauelemente, welche mit dem erfindungsgemäßen Fixiertropfen versehen wurden, unter 0,3 K/mW.

### Beispiel 2:

Es wurden zehn Bauelemente mit Anschlussdrähten aus Platin, welche mit dem SilikonFixiertropfen elektrisch isoliert wurden, hergestellt und einem Auslagerungstest unterworfen. Es handelte sich hierbei um Pt1000 Temperatursensoren.

Die Bedingungen für den Auslagerungstest sahen vor, dass die passiven Bauelemente für 1000 Stunden einer Umgebungstemperatur von 85°C und einer Luftfeuchtigkeit 85% ausgesetzt wurden. Vor und nach dem Test wurde der Widerstand der Bauelemente bei 0°C bestimmt und daraus ein Temperaturwert berechnet. Die Differenz dieser gemessen Temperaturwerte im selben Bauteil ist die Drift dieses Bauteils.

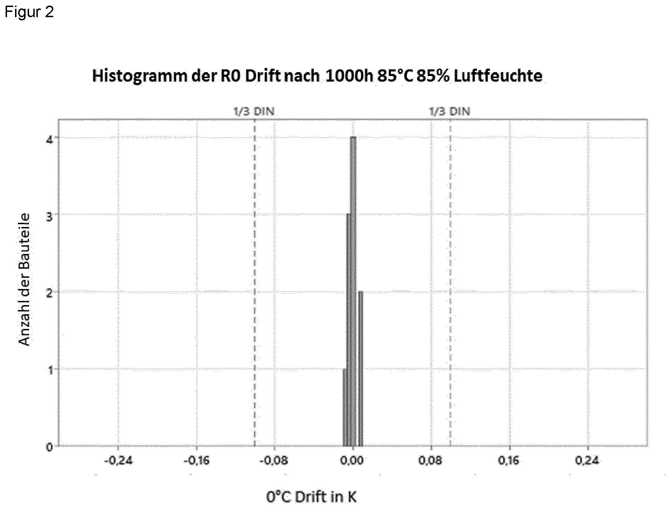

Die Messergebnisse sind in Figur 2 dargestellt.

Es ergab sich zudem, dass alle untersuchten Temperatursensoren die Bedingungen für einen Sensor der Güteklasse 1/3 DIN (AA) auch nach dem Auslagerungstest eingehalten haben.

### Beispiel 3:

Auf ein 50 µm dickes FeCrAI-Stahlblech, das zuvor oberflächlich mit einer dichten isolierenden Oxidschicht versehen wurde, wird per Siebdruck mit einer Silberpaste eine Widerstandsstruktur sowie 2 Kontaktpads aufgedruckt. Anschließend wird der Widerstandsbereich mit einer dünnen Glasschicht passiviert, die Kontaktpads dabei aber ausgespart. An die Kontaktpads werden Zuleitungsdrähte angebracht. Die Silikonfixiertropfen werden über den Verbindungsstellen aufgebracht und durch UV-Strahlung polymerisiert. Nach der Herstellung wurde das Bauteil aus dem Metallnutzen durch Laservereinzelung herausgetrennt.

Das so aufgebaute Heizelement wurde resistiv 400-mal auf 150°C aufgeheizt, und wieder auf Raumtemperatur abgekühlt. Der dafür benötigte Heizstrom hat sich über die Versuchsdauer nicht erkennbar verändert.

### Beispiel 4:

Eine Serie Heizelementen identisch zu Beispiel 3 wurde hergestellt. Die Größe eines Heizelementes war 10 mm × 30 mm. Die Anschlussdrähte wurden parallel zur langen Substratseite angebracht. Dabei wurden 20 Heizelemente auf demselben Blech der 25 cm × 3 cm hergestellt und nicht voneinander getrennt. Die Anschlussdrähte aller Heizelemente wurden parallel angebracht. Das Blech wurde entlang der langen Seite im Halbkreis gebogen. Auch im gebogenen Zustand funktionierten die Heizelemente noch und die elektrische Isolierung der Anschlussdrähte blieb gewährleistet. Eine Erwärmung auf 150°C im gebogenen Zustand war möglich. Der Streifen bleib federnd und ließ sich nach dem Aufheizen auch wieder in einen flachen Zustand bringen. Auch dann waren alle 20 Heizelement funktionstüchtig.

## Patentansprüche

1. Fixiertropfen, zur elektrischen Isolierung von Kontaktpads und den daran kontaktierten Anschlussdrähten an passiven Bauelementen, insbesondere Sensoren, vorzugsweise Temperatursensoren, auf einem anorganischen Substrat, insbesondere Metalloxid-, Halbleiter-, Metall- und/oder Glassubstrat,
**dadurch gekennzeichnet, dass**
der Fixiertropfen eine hydrophobe Polymerzusammensetzung umfasst.

2. Fixiertropfen gemäß Anspruch 1,
**dadurch gekennzeichnet, dass**
die Polymerzusammensetzung ein Silikon, bevorzugt Flüssig-Silikon-Kunststoff oder Polyimide, insbesondere Einkomponenten-Polymere umfasst.

3. Fixiertropfen gemäß einem der vorhergehenden Ansprüche,
**dadurch gekennzeichnet, dass**
die Polymerzusammensetzung mindestens einen partikelförmigen Füllstoff ausgewählt aus der Gruppe bestehend aus Oxidkeramiken, Nitriden und Carbiden, besonders bevorzugt SiO₂, Al₂O₃, SiN, SiC, TiO₂, MgO, ZrO₂, oder Mischoxide daraus oder andere Metallnitride, oder Gläser umfasst, und/oder der Füllstoff eine Partikelgrößenverteilung mit einem D₅₀ von kleiner als 50 µm, insbesondere mit einem D₅₀ kleiner 5 µm, besonders bevorzugt von 0,8 µm bis 1,3 µm, ermittelt durch Laserdiffraktion, aufweist.

4. Fixiertropfen gemäß einem der vorhergehenden Ansprüche,
**dadurch gekennzeichnet, dass**
der Ausdehnungskoeffizient der Polymerzusammensetzung größer ist als der Ausdehnungskoeffizient des Substrates und/oder der Anschlussdrähte und/oder der Kontaktpads.

5. Fixiertropfen gemäß Anspruch 3 oder 4,
**dadurch gekennzeichnet, dass**
der mindestens eine Füllstoff in einer Menge von 3 bis 60 Gew.-%, vorzugsweise von 5 bis 13 Gew.-%, besonders bevorzugt von 7 bis 11 Gew.-%, bezogen auf die Gesamtmasse des Fixiertropfens, vorliegt.

6. Fixiertropfen gemäß einem der vorhergehenden Ansprüche,
**dadurch gekennzeichnet, dass**
der Fixiertropfen weniger als 35 Vol.-%, vorzugsweise weniger als 25 Vol.-%, bevorzugt weniger als 15 % an Poren aufweist, und/oder keine offene Porosität zeigt.

7. Passives Bauelement, insbesondere Sensor, vorzugsweise Temperatursensor, umfassend Anschlussdrähte und ein anorganisches Substrat, insbesondere Metalloxid-, Halbleiter- und/oder Glassubstrat,
**dadurch gekennzeichnet, dass**
die Kontaktpads und die daran kontaktierten Anschlussdrähte durch einen Fixiertropfen gemäß einem der Ansprüche 1 bis 6 elektrisch isoliert sind, wobei vorzugsweise das komplette Bauteil über den Anschlussdrähten eine Höhe von kleiner als 0,8 mm, bevorzugt kleiner als 0,75 mm, besonders bevorzugt kleiner als 0,7 mm, aufweist.

8. Passives Bauelement gemäß Anspruch 7
**dadurch gekennzeichnet, dass**
das passive Bauelement durch Vereinzelung erhalten wurde, wobei das Vereinzeln vorzugsweise ein Brechen, insbesondere an mindestens einer Sollbruchstelle, und/oder Sägen, umfasst.

9. Passives Bauelement gemäß Anspruch 7 oder 8,
**dadurch gekennzeichnet, dass**
das passive Bauelement eine Eigenerwärmung von weniger als 0,4 K/mW, bevorzugt von weniger 0,35 K/mW, besonders bevorzugt 0,3 K/mW, aufweist.

10. Passives Bauelement gemäß einem der Ansprüche 7 bis 9,
**dadurch gekennzeichnet, dass**
die Anschlussdrähte Nickel- oder Kupferdraht, optional mit Kunststoff-, Silber- oder Platinmantel umfassen.

11. Passives Bauelement gemäß einem der Ansprüche 7 bis 10,
**dadurch gekennzeichnet, dass**
die Anschlussdrähte Nickeldraht mit einem Mantel umfassen, wobei der Mantel vorzugsweise aus Glasfaser, Silikone, Teflon, PEEK, Polyurethan, Kresole, Polyimide, Polyesterimide, PMA, PMAA, oder Viton oder gefülltem Kunststoff ausgewählt ist, und der Mantel am Anschlussdraht vor dem Auftragen des Fixiertropfen befestigt wurde und/oder in den Fixiertropfen hineinragt.

12. Verfahren zur Herstellung von passiven Bauelementen, insbesondere nach einem der Ansprüche 7 bis 11, umfassend die Schritte:
- Bereitstellen eines anorganischen Substrats, insbesondere eines Metalloxid- oder Halbleitersubstrats oder eines Glassubstrats, auf dem mehrere Strukturen, insbesondere in Reihe, angeordnet sind,
- Anbringen von mindestens einem Anschlussdraht an jedem der Kontaktpads der Strukturen,
- Bedecken der Kontaktpads und der Spitzen der Anschlussdrähte durch Aufbringen einer Polymerpaste, insbesondere umfassend eine Polymerzusammensetzung gemäß einem der Ansprüche 1 bis 6,
- Wärmebehandlung der Polymerpaste, insbesondere bei einer Temperatur von 120 bis 375 °C, bevorzugt 120°C bis 300°C, weiter bevorzugt von 140 bis 220 °C, um einen Fixiertropfen, insbesondere gemäß der Ansprüche 1 bis 7, zu erhalten
- Abkühlen des Fixiertropfens auf eine Temperatur bei der der Fixiertropfen formstabil (und noch elastisch) ist, vorzugsweise auf Raumtemperatur
- Vereinzelung der passiven Bauelemente, insbesondere durch das Sägen oder Laserschneiden des anorganischen Substrats und des durchgängigen Fixiertropfens.

13. Verfahren nach Anspruch 12, wobei es sich beim Vereinzeln um ein Brechverfahren handelt, welches die Einbringung von Sollbruchstellen in dem anorganischen Substrat zwischen den Strukturen beinhaltet, insbesondere mittels eines Lasers und/oder mittels mechanischer Abtragung.

14. Passives Bauelement, erhältlich durch das Verfahren nach Anspruch 12 oder 13.

15. Verwendung eines Fixiertropfens nach einem der Ansprüche 1 bis 6 zur elektrischen Isolation der Kontaktstelle von Anschlussdrähten und den Kontaktpads an passiven Bauelementen, insbesondere gemäß einem der Ansprüche 7 bis 11 oder Anspruch 14.
